# EUROPEAN PATENT APPLICATION

(11) **EP 4 745 970 A1**
(43) Date of publication of application: **20.05.2026**
(21) Application number: 25211206.5
(22) Date of filing: 24.10.2025
(51) Int. Cl.: G11C 13/00

(54) **METHOD OF PERFORMING WRITE OPERATIONS IN PHASE CHANGE MEMORIES, CORRESPONDING DEVICE AND COMPUTER PROGRAM PRODUCT**

(30) Priority: 15.11.2024 IT 202400025794
(71) Applicant: STMicroelectronics International N.V., 1228 Plan-les-Ouates, Geneva (CH)
(72) Inventor: DE COSTANTINI, Diego, 96011 Augusta (Siracusa) (IT); CONTE, Antonino, 95030 Tremestieri Etneo (Catania) (IT); TOMAIUOLO, Francesco, 95024 Acireale (Catania) (IT)
(74) Representative: Buzzi, Notaro & Antonielli d'Oulx S.p.A.

(57) **Abstract**

A method (40) of performing write operations in Phase Change Memory devices comprising writable memory sections, each writable memory section being coupled to a respective non-volatile memory section having stored therein information indicating if the latest write operation performed on the writable memory section has been performed via pulses comprised in a first set or in a second set of current pulses, such second set comprising pulses having lower current values than pulses comprised in such first set.

The method (40) comprises: receiving (400) a command to perform a write operation on a writable memory section via pulses comprised in either the first set or the second set;
in response to the information stored in the respective non-volatile memory section indicating (402) a latest write operation performed on the writable memory section via pulses comprised in the first set and the received command indicating to perform the write operation via pulses comprised in the second set, detecting (N₁, Y₃) a transition from the first set to the second set; and
in response to detection (N₁, Y₃) of a transition from the first set to the second set:
applying (418) a third current pulse to cells of the writable memory section that are in a reset state;
setting (420) the information stored in the respective non-volatile memory section to indicate a latest write operation performed on the writable memory section via pulses comprised in the second set; and
performing (422) the write operation on the writable memory section via pulses comprised in the second set.

## Description

### Technical field

The description relates to data storage technologies.

One or more embodiments can be applied to computer storage technologies such as non-volatile memories NVM, for instance, PCM, that is, Phase Change Memory such as ePCM (that is, embedded Phase Change Memory) and/or ePCM NVM (that is, Non-Volatile Memory ePCM).

### Background

Phase Change Memories, referred to as PCM, are a type of computer storage technology, that is, memory technology and, generally, a type of non-volatile random-access memory technology that can be embedded in integrated circuit (IC) semiconductor devices.

Usually, PCM operates on a bit-by-bit basis since the heat produced by an electric current flowing through a heating material called phase-change material, for instance, a chalcogenide glass such as GST ("Germanium-Antimony-Tellurium"), is used to melt and quench the phase-change material, making it amorphous, or to hold such phase-change material in its crystallization temperature range, thereby switching it to a crystalline state.

Therefore, a PCM storage unit may use such phase-change material to store 1-bit of information since the two states of the phase-change material, that is, amorphous or crystalline, are characterized by different resistance values that facilitate distinguishing one of the states from the other, that is, each of the two states corresponds to a different value of a single bit.

Thus, the phase-change material can stably exist in two states:
an amorphous or disordered state, characterized by high electrical resistivity, that is, by high resistance, for instance, about 0.6 MΩ, representing, for instance, a low logical state, for instance, '0', characterized by a low current flowing through it, or
a crystalline or ordered state, characterized by low electrical resistivity, that is, by low resistance, for example, a resistance lower than that of the amorphous state, for instance, about 18 kΩ, representing, for instance, a high logical state, for instance, '1', characterized by a high current flowing through it.

A PCM storage unit can switch between such two states by differently heating the phase-change material, that is, by applying a current to such phase-change material for a given time for switching to a first state and by applying a current of different value to such phase-change material for a different time for switching to a second state.

For instance, a "set" write operation of a specific cell, that is, setting the cell to a high logic level, may be performed by applying on the phase-change material of such specific cell a current (for instance, a current pulse with triangular shape) that heats the respective phase-change material above a crystallization temperature associated with such respective phase-change material, but under a melt temperature associated with the same phase-change material, for a given time.

For instance, a "reset" write operation of a specific cell, that is, setting the cell to a low logic level, can be performed by applying on the phase-change material of such specific cell a current (for instance, a short rectangular current pulse) that heats the respective phase-change material above the melt temperature associated with such respective phase-change material for a given time, for instance, shorter than the one considered in a "set" write operation.

For instance, a read operation of a specific cell may be done by testing the resistance value, for instance, through a current pulse, of the phase-change material of the specific cell in order to detect the current phase, that is, amorphous or crystalline, of the phase-change material.

It is noted that "set" write operations and "reset" write operations may be collectively referred to as write operations in the following description, therefore, a write operation performed on a given cell may be either a set write operation, that is, to set such given cell to a high logic level, or a reset write operation, that is, to set such given cell to a low logic level.

A single-ended PCM is a type of PCM wherein a single cell corresponds to a single bit (that is, 1 cell/bit).

Read operations in single-ended PCM are performed by using a reference current supplied, for instance, by a reference current generator, and a sense amplifier receiving:
at one terminal, a current from a PCM cell that is to be read, and
at the other terminal, a reference current supplied by the reference-current generator.

Document US 2009/0161417 A1 discloses two-cells-per-bit PCM architecture (that is, 2 cell/bit), that is, PCM architecture wherein two cells contain a single bit of data and one of the two cells, a complementary cell, is programmed to the complementary state of the other of the two cells. Thus, a bit is determined by reading a bit stored in one of the two cells and comparing it to the one stored in the complementary cell, thus, performing a differential reading operation.

A differential reading operation considers both the stored value of such data in a cell in its direct form, that is, high or low logic level respectively, and the stored value of such data in a complementary cell in its complemented form, that is, low or high logic level respectively.

Hence, the result of the differential reading operation is obtained through the use of a sense amplifier that is configured to receive at one terminal, for instance, on a first side, for instance, a left side, or on a second side, for instance, a right side, a current of the "direct" cell that has to be read, that is, containing the data in the direct form, and at the other terminal, for instance, on the second side or on the first side respectively, a current of the associated complementary cell, that is, containing the data in the complemented form.

Thus, the "direct" cell and the complementary cell are configured to be in opposite states. For instance, if one of the two cells, for instance, the direct cell, is in a SET state (characterized by low resistance and high current), the complementary cell is in a RESET state (characterized by high resistance and low current), or vice versa.

Therefore, the sense amplifier is configured to compare the current received from the direct cell and the current received from the associated complementary cell, and:
if the current received from the direct cell is higher than the current received from the associated complementary cell, the sense amplifier is configured to read a logic level equal to 1 ("one"), that is, a high logic level, and
if the current received from the direct cell is lower than the current received from the associated complementary cell, the sense amplifier is configured to read a logic level equal to 0 ("zero"), that is, a low logic level.

As a result, a reading operation of a bit in a two-cells-per-bit PCM may be more reliable than reading operations of bits in single-ended PCMs, as a read window in two-cells-per-bit PCMs is twice as wide as that used in single-ended PCMs.

The read window in two-cells-per-bit PCMs depends on a difference between a current flowing in a direct cell and a current flowing in an associated complementary cell, which corresponds to a difference between a current flowing within a cell set to a high logic level, that is, a current flowing in a direct or in a complementary cell, and a current flowing in a cell set to a low logic level, that is, a current flowing in a complementary or in a direct cell respectively.

Conversely, the read window in single-ended PCMs depends on a difference between a current flowing in a cell, that is, a current flowing within a cell set to a high or a low logic level, and a reference current, such reference current being midway between a current flowing within a cell set to a high logic level and a cell set to a low logic level.

Hence, two-cells-per-bit PCM architectures improve the reliability of read operations as a reference current is not needed since read operations are based on differential readings and as the two-cells-per-bit read window is doubled.

In addition, two-cells-per-bit PCM architectures may usually provide higher robustness, reliability, and retention at hot than single-ended PCM architectures as two-cells-per-bit PCMs are characterized by:
redundancy of information, that is, a single bit is stored in two cells instead of a single one, and
the possibility of implementing a differential reading strategy, that is, allowing the reading of the content of cells without using a reference current.

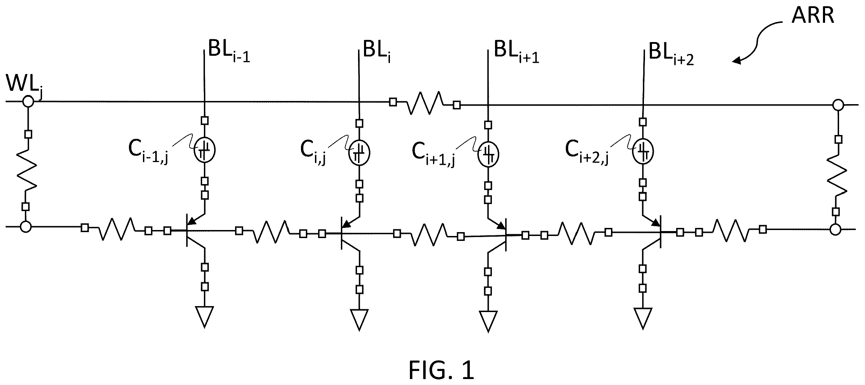

Figure 1 illustrates a conventional structure of a PCM array ARR.

A PCM array ARR, for instance, a two-cells-per-bit PCM array, may comprise one or more sets of cells, for instance, comprising cells C_{i-1,j}, C_{i,j}, C_{i+1,j}, and C_{i+2,j} of Figure 1, that are collectively referred to with the reference C, coupled together.

It is noted that the resistances of Figure 1 are not physical elements but arise from parasitic connections.

It is noted that such one or more sets of cells C may be comprised in different subset of the array, for instance, either in a first subset of the PCM array ARR, for instance, a subset of the PCM array comprising cells that are coupled to a first side of a sense amplifier, for instance, a left side, or in a second subset of such PCM array ARR, for instance, a subset of the PCM array comprising cells that are coupled to a second side of such sense amplifier, for instance, a right side.

It is noted that, if a direct cell is comprised in the first subset of the PCM array ARR, the respective complementary cell is comprised in the second subset of the PCM array ARR, and vice versa.

The one or more sets of cells comprised in the PCM array are arranged in word lines WL, that are, the rows of the array, and bit lines BL, that are, the columns of the array.

Each cell in the plurality of cells C is coupled to a respective bit line BL and to a respective word line WL, for instance, through a bipolar transistor acting as selector.

Each cell in the plurality of cells C is coupled to a different pair of lines comprising a bit line BL and a word line WL, so that the respective bit line BL and the respective word line WL to which a given cell is coupled can be considered as providing coordinates to unambiguously identify such given cell.

For instance, the set of cells C illustrated in Figure 1 is comprised in a word line WLⱼ and each of such cells C is further coupled with a respective bit line, for instance, to a bit line BLᵢ₋₁, BLᵢ, BLᵢ₊₁, or BLᵢ₊₂ of Figure 1, that are collectively referred to with the reference BL.

It is noted that the cells C of the PCM array ARR may also be organized in tiles, such tiles being memory sub-blocks (that is, array sub-blocks) comprising cells that are arranged in bit lines BL and word lines WL, each of such tiles being accessible and operable independently.

The stability in temperature of the states of the PCM cells C, that is, the stability of the amorphous state and that of the crystalline state of the cells C, depends on the value of the currents used to program such cells C, that is, on the value of the currents used to perform "set" write operations for cells programmed to high logic levels (cells in a "set" state) and "reset" write operations for cells programmed to low logic levels (cells in a "reset" state).

To improve the stability in temperature of the states of the PCM cells at high temperatures, for instance, temperatures up to 400°C, which can be reached, for instance, during soldering operations, the value of the currents used to program the PCM cells in such high temperature conditions is to be higher than the value of the currents used to program such PCM cells in lower temperature conditions, for instance, in temperature conditions related to a normal operation of the PCM.

It is noted that the currents used to program such PCM cells in such lower temperature conditions, for instance, in temperature conditions related to the normal operation of the PCM, are referred to in the following description as user pulses.

It is noted that the currents used to program the PCM cells in the previously described high temperature conditions, that is, in temperatures higher than those related to the normal operation of the PCM, for instance, in temperatures reachable during soldering operations, are referred to in the following description as power pulses.

It is noted that the current values comprised in a range related to the currents of the power pulses are higher than the current values comprised in a range related to the currents of the user pulses.

By way of example, the currents of the power pulses may have values of about 350 microamperes ("µA"), while the currents of the user pulses may have values of about 150 microamperes ("µA").

However, even though the stability in temperature of the states of the PCM cells is improved by using power pulses instead of user pulses, the use of such power pulses (that have higher current values than those of the user pulses) instead of the user pulses leads to faster degradation of the PCM cells in case of cycles of writing operations.

Therefore, in view of the above, it is possible to perform writing operations (set write operations and/or reset write operations) by applying two types of pulses to the PCM cells:
user pulses, having lower current values than the power pulses and leading to less stability in temperature and less degradation of the PCM cells during cycles of writing operations if compared with the power pulses, therefore, such user pulses may be used in temperature conditions related to the normal operation of the PCM in order to have the possibility to apply to the PCM cells a higher number of cycles of writing operations; and
power pulses, having higher current values than the user pulses and leading to more stability in temperature, that is, to better retention allowing to retain the content of the cells also at the previously described high temperatures (for instance, during soldering), and to more degradation of the PCM cells during cycles of writing operations if compared with the user pulses.

It is noted that a PCM cell can be set to a "set" state, storing a high logic level, by holding the phase-change material in its crystallization temperature range, thereby switching it to a crystalline state, via either a set user pulse or a set power pulse.

Similarly, a PCM cell can be set to a "reset" state, storing a low logic level, by melting and quenching the phase-change material, making it amorphous, via either a reset user pulse or a reset power pulse.

In view of the above, PCMs according to known solutions have a first part of the memory configured to be written via power pulses, for instance, to pass the soldering, and a second part of the memory configured to be written via user pulses, for instance, used during normal operation of the PCM.

In known solutions, such first part of the memory is always re-written via power pulses and such second part of the memory is always re-written via user pulses.

Therefore, the transition between power pulses and user pulses is not allowed, leading to a limitation related to the number of cycles of writing operations that can be performed on the first part of the memory.

Solutions facilitating the transition between power pulses and user pulses would be beneficial in order to reduce the degradation of the PCM cells during cycles of writing operations without losing or compromising retention capabilities at high temperatures, for instance, during soldering.

### Object and summary

An object of one or more embodiments is to contribute in providing such solutions that facilitate the transition between power pulses and user pulses in order to reduce the degradation of the PCM cells during cycling without losing retention capabilities during soldering.

According to one or more embodiments, that object is achieved via a method of performing write operations in phase change memories having the features set forth in the claims that follow.

One or more embodiments concern a corresponding memory device and a corresponding computer program product loadable in at least one processing circuit (for instance, a computer) and comprising software code portions for executing the steps of the method when the product is run on at least one processing circuit.

As used herein, reference to such a computer program product is understood as being equivalent to reference to a computer-readable medium containing instructions for controlling a processing system in order to co-ordinate implementation of the method according to one or more embodiments.

The claims are an integral part of the technical teaching provided in respect of the embodiments.

Solutions as described herein include a method of performing write operations in Phase Change Memory, PCM, devices comprising writable memory sections.

Each writable memory section, for instance, a word of the memory, is coupled to a respective non-volatile memory section, for instance, an additional non-volatile bit, having stored therein information indicating whether the latest write operation performed on the writable memory section has been performed via pulses comprised in a first set of current pulses (which are referred to as power pulses in the following description) or in a second set of current pulses (which are referred to as user pulses in the following description).

It is noted that said second set of current pulses comprising pulses, that is, user pulses, having lower current values than pulses, that is, power pulses, comprised in said first set of current pulses.

The method described herein comprises:
receiving a command to perform a write operation on a writable memory section via pulses comprised in either the first set of current pulses or the second set of current pulses, therefore, receiving a command to perform a write operation via pulses comprised in the first set of current pulses or a command to perform a write operation via pulses comprised in the second set of current pulses;
in response to the information stored in the respective non-volatile memory section indicating a latest write operation performed on the writable memory section via pulses comprised in the first set of current pulses and the received command indicating to perform said write operation via pulses comprised in the second set of current pulses, detecting a transition from the first set of current pulses to the second set of current pulses; and
in response to detection of a transition from the first set of current pulses to the second set of current pulses:
   applying a third (blanking) current pulse to cells of the writable memory section that are in a "reset" state;
   setting the information stored in the respective non-volatile memory section to indicate a latest write operation performed on the writable memory section via pulses comprised in the second set of current pulses; and
   performing the write operation on the writable memory section via pulses comprised in the second set of current pulses, that is, via "set" current pulses and/or "reset" current pulses comprised in the second set of current pulses.

Therefore, solutions as described herein facilitate the transition between power pulses and user pulses in order to reduce the degradation of the PCM cells during cycling, that is, during cycles of writing operations, without losing or compromising the retention capabilities at high temperatures, for instance, during soldering.

### Brief description of the figures

One or more embodiments will now be described, by way of example only, with reference to the annexed figures, wherein:
Figure 1 is a conventional structure of a PCM array;
Figure 2 illustrates a behavior of currents flowing in PCM cells after a transition from power pulses to user pulses according to embodiments of the present description;
Figure 3 is a block diagram related to a method of performing write operations in correspondence of a transition from power pulses to user pulses according to embodiments of the present description;
Figure 4 is a block diagram related to a method of performing write operations in correspondence of a transition from user pulses to power pulses according to embodiments of the present description; and
Figure 5 is a block diagram related to a method of performing write operations considering transitions from power pulses to user pulses and vice versa according to embodiments of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular configurations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

As described above, solutions as described herein aim at facilitating the transition between the use of power pulses and the use of user pulses (and, possibly, vice versa) during write operations in order to reduce the degradation of the PCM cells during cycling, that is, during cycles of writing operations, maintaining the retention capabilities at high temperatures, for instance, during soldering.

A first solution for allowing such a transition comprises using:
power pulses to perform set and/or reset write operations when the PCM cells are expected to be exposed to high temperature conditions, that is, to temperatures higher than those related to the normal operation of the PCM, for instance, temperatures reachable during soldering operations, therefore, for instance, such power pulses may be used to store data in the PCM cells C before soldering; and
user pulses to perform set and/or reset write operations when the PCM cells are expected to operate in normal (standard) conditions, that is, when the PCM cells are not exposed to such high temperature conditions, therefore, for instance, such user pulses may be used to store data in the PCM cells C after soldering.

It is noted that in the following description the wording "first set of current pulses" is referred to a set comprising power pulses, such power pulses being set or reset power pulses and having higher values than respective set or reset user pulses.

Similarly, it is noted that in the following description the wording "second set of current pulses" is referred to a set comprising user pulses, such user pulses being set or reset user pulses and having lower values than respective set or reset power pulses.

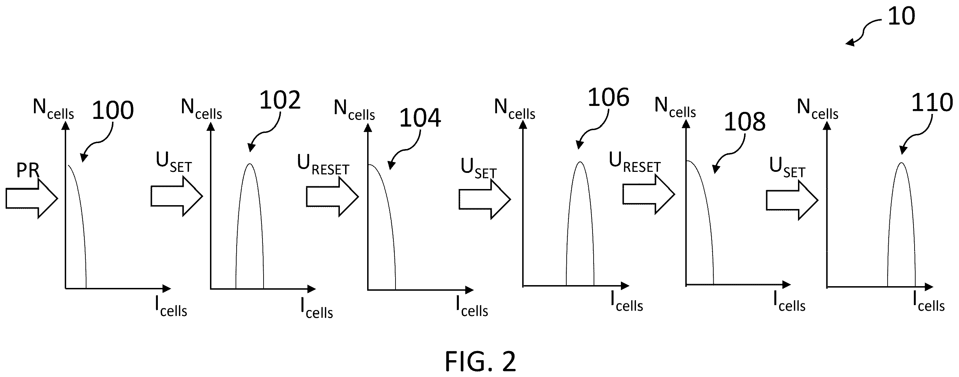

Figure 2 illustrates a behavior 10 of currents I_{cells} flowing in PCM cells C after a transition from power pulses PR, to be used to store the content of the PCM cells before soldering, to user pulses U_{SET} or U_{RESET}, to be used to cycle the PCM cells after soldering, that is, to perform subsequent write operations after soldering, according to embodiments of the present description.

It is noted that the transition between the use of power pulses PR for writing operations, for instance, Figure 2 illustrates a first cell distribution 100 (that is, a distribution indicative of the number of cells N_{cells} through which a given current I_{cells} is flowing) obtained in response to a reset write operation performed via a reset power pulse PR, and the use of user pulses U_{SET} or U_{RESET} requires a plurality of set user pulses U_{SET} and reset user pulses U_{RESET} cycles, for instance, referring to the exemplary sequence of cell distributions 102-110 of Figure 2, to obtain a distribution opening window that facilitate reading operations.

In fact, such distribution opening window is defined as a current difference between the lowest current flowing in a cell of a cell distribution obtained in response to a set write operation, for instance, the lowest current flowing in a cell of the set cell distribution 102, 106, or 110, and the highest current flowing in a cell of a cell distribution obtained in response to a reset write operation, for instance, the highest current flowing in a cell of the reset cell distribution 100, 104, or 108, respectively.

Therefore, a wider distribution opening window leads to reading operations that are less likely to fail since the values of the currents flowing in cells in "set" states are higher and farther from the values of the currents flowing in cells in "reset" states.

The plurality of set user pulses U_{SET} and reset user pulses U_{RESET} cycles used to obtain a desired distribution opening window is requested due to a cell "power memory effect" leading to the fact that a PCM cell previously written via a reset write operation using a reset power pulse PR may not be moved in a state comprised in a desired set cell distribution by performing a set write operation using a set user pulse U_{SET} since such set user pulse U_{SET} has a lower current value than the reset power pulse PR used for the reset write operation.

By way of example, Figure 2 illustrates the following sequence of cell distributions:
the first distribution 100 of cells is related to cells that are set to a "reset" state via a first reset write operation performed via a reset power pulse PR, such first distribution 100 being indicative of the number of such cells N_{cells} through which a given current I_{cells} is flowing after such first reset write operation;
a second distribution 102 of such cells is related to cells that are set to a "set" state via a first set write operation performed via a first set user pulse U_{SET}, such second distribution 102 being indicative of the number of such cells N_{cells} through which a given current I_{cells} is flowing after such first set write operation, that is, after a first cycle of write operations performed via user pulses;
a third distribution 104 of such cells is related to cells that are set to a "reset" state via a second reset write operation performed via a first reset user pulse U_{RESET}, such third distribution 104 being indicative of the number of such cells N_{cells} through which a given current I_{cells} is flowing after such second reset write operation, that is, after a second cycle of write operations performed via user pulses;
a fourth distribution 106 of such cells is related to cells that are set to a "set" state via a second set write operation performed via a second set user pulse U_{SET}, such fourth distribution 106 being indicative of the number of such cells N_{cells} through which a given current I_{cells} is flowing after such second set write operation, that is, after a third cycle of write operations performed via user pulses;
a fifth distribution 108 of such cells is related to cells that are set to a "reset" state via a third reset write operation performed via a second reset user pulse U_{RESET}, such fifth distribution 108 being indicative of the number of such cells N_{cells} through which a given current I_{cells} is flowing after such third reset write operation, that is, after a fourth cycle of write operations performed via user pulses; and
a sixth distribution 110 of such cells is related to cells that are set to a "set" state via a third set write operation performed via a third set user pulse U_{SET}, such sixth distribution 110 being indicative of the number of such cells N_{cells} through which a given current I_{cells} is flowing after such third set write operation, that is, after a fifth cycle of write operations performed via user pulses.

It is noted the number of cycles considered in Figure 2 is only an exemplary number, therefore, even more cycles may be required to obtained the desired distribution opening window.

It is noted that such cycling is costly both in terms of time and power consumption, therefore, solutions that avoid such cycling may be advantageous.

To facilitate the transition between the use of power pulses and the use of user pulses in write operations without performing set user pulses U_{SET} and reset user pulses U_{RESET} cycles to obtain a desired distribution opening window, solutions as described herein associate an additional non-volatile bit (or more than one bit) to each memory section, for instance, to each word of the memory, that can be written (that is, to a part of the memory that can be written).

For instance, an additional non-volatile bit may be comprised in each memory address that addresses a respective memory section that can be written.

It is noted that in the following description the wording "writable memory section" is referred to such memory sections, for instance, the words of the memory, that can be written in response to a write command.

Similarly, it is noted that in the following description the wording "non-volatile memory section" is referred to the additional non-volatile bit or to additional non-volatile bits associated to respective writable memory sections.

The additional non-volatile bit indicates, for a respective part of the memory that can be written (for instance, addressed via a respective memory address that comprises such additional non-volatile bit), the type of the latest pulse, that is, either power pulse or user pulse, used to program, that is, to write, the content of such part of the memory.

For instance, if a part of the memory (such as a word of the memory) has been written via power pulses (for instance, in response to a power write command indicating to perform write operations using power pulses), the additional non-volatile bit may be set to a high logic level.

Otherwise, if such part of the memory has been written via user pulses (for instance, in response to a user write command indicating to perform write operations using user pulses), the additional non-volatile bit may be set to a low logic level.

The PCM array ARR can be organized in order to associate, for instance, a group of data bits (that is, a word, for instance, of 128 bits), to each memory address. Therefore, the previously described additional non-volatile bits may also be comprised in such groups of data bits associated to respective memory addresses.

Therefore, solutions as described herein refers to a method wherein each writable memory section, for instance, each writable word of the memory, may be addressed via a respective memory address and wherein the non-volatile memory section, that is, the additional non-volatile bit(s), may be comprised:
in such respective memory address; or
in a group of bits, preferably a word, coupled to such respective memory address.

Hence, solutions as described herein may recognize, based on the state of the additional non-volatile bit and on a type of write operation that is to be performed (for instance, based on whether a write command that is to be executed is a power write command or a user write command), if a transition from power pulses to user pulses or vice versa is present.

If a transition from power pulses to user pulses is detected, that is, if the additional non-volatile bit associated to a part of the memory that is to be written via a write command indicates that the type of the latest pulse used to program such part of the memory is a power pulse but the write command is a user write command, solutions as described herein may be configured to perform a recovery or blanking sequence step and a power to user writing step.

If a transition from user pulses to power pulses is detected, that is, if the additional non-volatile bit associated to a part of the memory that is to be written via a write command indicates that the type of the latest pulse used to program such part of the memory is a user pulse but the write command is a power write command, solutions as described herein may be configured to perform a user to power writing step.

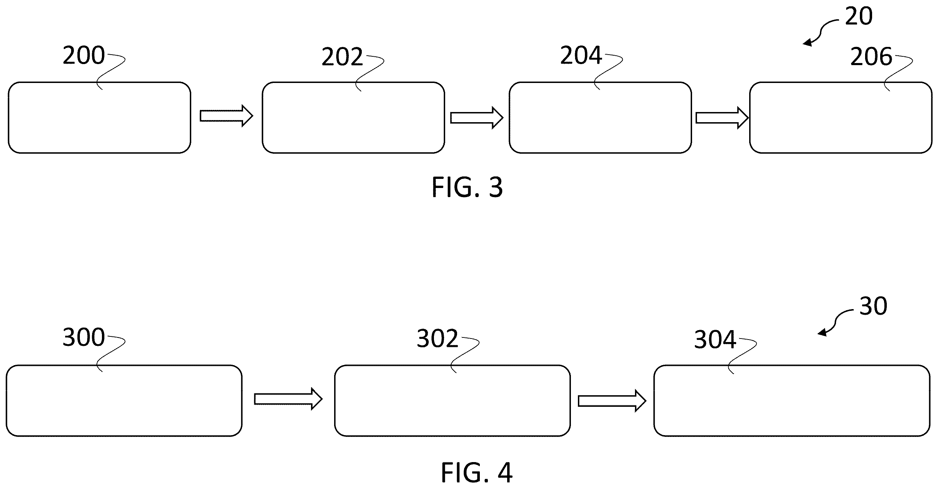

Figure 3 illustrates a block diagram 20 related to a method of performing write operations in correspondence of a transition from power pulses to user pulses according to embodiments of the present description.

In a first writing step 200 of Figure 3, a part of the memory, such as a word, is written via a power write command indicating to perform a write operation using power pulses.

Therefore, in such first writing step 200, the additional non-volatile bit associated to such part of the memory is set to indicate that the type of the latest pulse is a power pulse, for instance, by assuming a high logic level.

In a second writing step 202, a user write command is received, such user write command indicating to perform a write operation over such part of the memory using user pulses.

Therefore, in such second writing step 202, a transition from power pulses to user pulses is detected.

Hence, the block diagram 20 of Figure 3 proceeds to the recovery or blanking sequence step 204 wherein a recovery blanking (or third) pulse is applied to the cells:
that are set to a "reset" state as a consequence of the write operation performed according to the power write command in the first writing step 200, and
that are comprised in the part of the memory that is to be written according to the user write command received in the second writing step 202.

Such recovery or blanking sequence step 204 is used to mitigate, for instance, by removing, the effects of the cell "power memory effect", facilitating moving a PCM cell previously written via a reset write operation using a reset power pulse PR in a state comprised in a desired set cell distribution (that is, a set cell distribution related to a desired distribution opening window) by performing a set write operation using a set user pulse U_{SET} even if the set user pulse U_{SET} has a lower current value than the reset power pulse PR used for the previous reset write operation.

Therefore, the previously described problem related to the obtaining of a desired distribution opening window in order to facilitate reading operations is also mitigated.

It is noted that such recovery blanking pulse (also referred to as third current pulse) may be a set power pulse. Alternatively, such recovery blanking pulse may have a maximum value and/or a shape different from the maximum value and/or the shape of set power pulses. In such a case, the maximum value and/or the shape of the recovery blanking pulse may be chosen based on the technologies used to implement the PCM memory, provided that such recovery blanking pulse is able to mitigate, for instance, by erasing, the effects of the previously described cell "power memory effect" in those cells that are in a reset state after a write operation performed using reset power pulses.

Then, in the power to user writing step 206 a write operation over the part of the memory that is to be written is performed according to the user write command received in the second writing step 202, therefore, by applying user pulses to the cells comprised in such part of the memory in order to store respective data.

In addition, in the power to user writing step 206, the additional non-volatile bit associated to such part of the memory is set to indicate that the type of the latest pulse used for a write operation is a user pulse, for instance, by assuming a low logic level.

Therefore, solutions as described herein refers to a method 20 of performing write operations in Phase Change Memory, PCM, devices comprising writable memory sections, that is, memory sections that can be written in response to a write command, for instance, writable words of the memory.

Each writable memory section, for instance, each word of the memory, is coupled to a respective non-volatile memory section, for instance, to an additional non-volatile bit or to a plurality of additional non-volatile bits, having stored therein information indicating whether the latest write operation performed on the writable memory section has been performed via pulses comprised in a first set of current pulses, that is, via power pulses, or in a second set of current pulses, that is, via user pulses.

It is noted that said second set of current pulses (that comprises the previously described user pulses) comprises pulses having lower current values than pulses comprised in said first set of current pulses (that comprises the previously described power pulses).

Such method 20 comprises the following operations:
receiving, for instance, in the previously described second writing step 202, a command to perform a write operation on a writable memory section via pulses comprised in either the first set of current pulses (power pulses) or the second set of current pulses (user pulses), thus, receiving either a power write command indicating to perform a write operation via power pulses or a user write command indicating to perform a write operation via user pulses;
in response to:
   the information stored in the respective non-volatile memory section indicating, for instance, again in the previously described second writing step 202, a latest write operation performed on the writable memory section via pulses comprised in the first set of current pulses, that is, via power pulses, and
   the received command indicating to perform said write operation via pulses comprised in the second set of current pulses, that is, by determining that such received command is a user write command indicating to perform a write operation via user pulses comprised in such second set of current pulses,
   detecting, for instance, again in the previously described second writing step 202, a transition from the first set of current pulses, that is, from using the power pulses to perform write operations over the considered writable memory section, to the second set of current pulses, that is, to using the user pulses to perform write operations over the considered writable memory section; and
   in response to detection of a transition from the first set of current pulses comprising such power pulses to the second set of current pulses comprising such user pulses:
      applying, for instance, in the previously described recovery or blanking sequence step 204, a blanking current pulse (for instance, the previously described recovery blanking pulse used in such recovery or blanking sequence step 204), that is, a current pulse able to mitigate, for instance, to remove, the effects of the previously described cell "power memory effect", to cells of the writable memory section that are in a "reset" state;
      setting, for instance, in the previously described power to user writing step 206, the information stored in the respective non-volatile memory section to indicate a latest write operation performed on the writable memory section via pulses comprised in the second set of current pulses, that is, via user pulses; and
      performing, for instance, again in the previously described power to user writing step 206, the write operation on the writable memory section via pulses comprised in the second set of current pulses, that is, via user pulses.

It is noted that such given current pulse, for instance, the recovery blanking pulse of the previously described recovery or blanking sequence step 204, may be comprised in the first set of current pulses, thus, being a set power pulse.

Alternatively, such given current pulse may not be comprised in such first set of current pulses, thus, having a maximum value and/or a shape different from the maximum value and/or the shape of set power pulses comprised in the first set of current pulses.

In such a case, the maximum value and/or the shape of the given current pulse may be chosen based on the technologies used to implement the PCM memory, provided that such given current pulse is able to mitigate, for instance, to remove, the effects of the previously described cell "power memory effect" in those cells that are in a reset state after a write operation performed using reset power pulses.

Figure 4 illustrates a block diagram 30 related to a method of performing write operations in correspondence of a transition from user pulses to power pulses according to embodiments of the present description.

In an initial writing step 300 of Figure 4, a part of the memory, such as a word, is written via a user write command indicating to perform a write operation using user pulses.

Therefore, in such initial writing step 300, the additional non-volatile bit associated to such part of the memory is set to indicate that the type of the latest pulse is a user pulse, for instance, by assuming a low logic level.

In a further writing step 302, a power write command is received, such power write command indicating to perform a write operation over such part of the memory using power pulses.

Therefore, in such further writing step 302, a transition from user pulses to power pulses is detected.

Hence, in the user to power writing step 304 a write operation over the part of the memory that is to be written is performed according to the power write command received in the further writing step 302, therefore, by applying power pulses to the cells comprised in such part of the memory in order to store respective data.

It is noted that the power pulses are applied to the cells of the part of the memory that is to be written even if such cells already store the expected data, thus, every cell comprised in the part of the memory that is to be written (and not only the cells that change their state) is to be re-written using power pulses even if it is already written via user pulses to the expected state.

In fact, by writing the content of the cells using the higher currents of the power pulses instead of the lower currents of the user pulses it is possible to improve the retention of the content in each cell comprised in such part of the memory.

In addition, in the user to power writing step 304, the additional non-volatile bit associated to such part of the memory is set to indicate that the type of the latest pulse used to perform a write operation on the considered part of the memory is a power pulse, for instance, by assuming a high logic level.

Therefore, the method 30 of solutions as described herein may comprise, in response to the reception of a command to perform a write operation (either a power write operation or a user write operation) on a writable memory section (for instance, a word of the memory) associated to a respective non-volatile memory section (for instance, one or more additional non-volatile bits), performing the following operations:
in response to:
the information stored in the respective non-volatile memory section indicating, for instance, in the previously described further writing step 302, a latest write operation performed on the writable memory section via pulses comprised in the second set of current pulses, that is, via user pulses, and
the received command indicating to perform said write operation via pulses comprised in the first set of current pulses, that is, by determining that such received command is a power write command indicating to perform a write operation via power pulses comprised in such first set of current pulses,
detecting, for instance, again in the previously described further writing step 302, a transition from the second set of current pulses, that is, from using the user pulses to perform write operations over the considered writable memory section, to the first set of current pulses, that is, to using the power pulses to perform write operations over the considered writable memory section; and
in response to the detection of a transition from the second set of current pulses comprising such user pulses to the first set of current pulses comprising such power pulses:
   setting, for instance, in the previously described user to power writing step 304, the information stored in the respective non-volatile memory section to indicate a latest write operation performed on the writable memory section via pulses comprised in the first set of current pulses, that is, via power pulses; and
   performing, for instance, again in the previously described user to power writing step 304, the write operation on the writable memory section via pulses comprised in the first set of current pulses, that is, via power pulses, by applying said pulses to all the cells of the writable memory section irrespective of their state being a "set" or a "reset" state, thus, rewriting all the cells that are to be written according to the received command in order to improve retention.

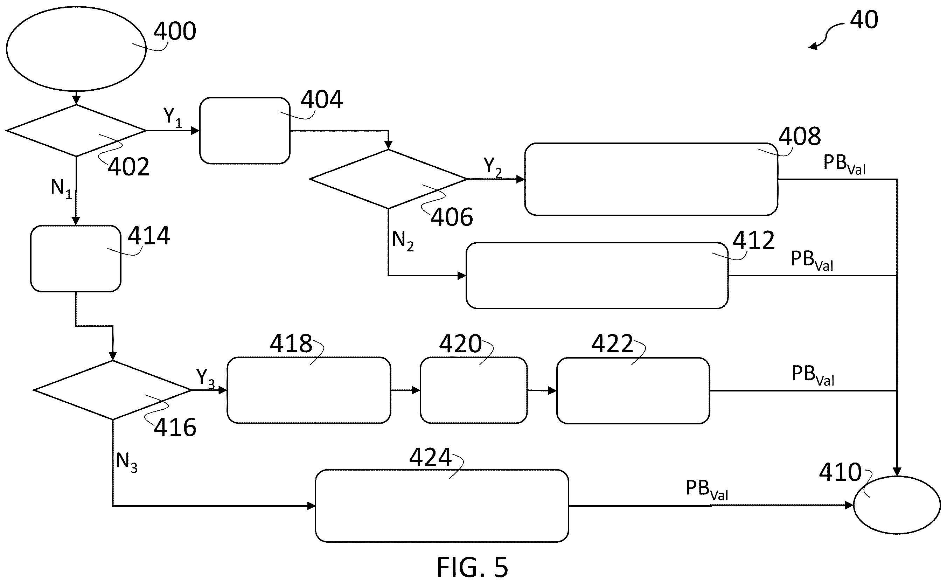

Figure 5 illustrates a block diagram 40 related to a method of performing write operations considering transitions from power pulses to user pulses and vice versa according to embodiments of the present description.

The block diagram 40 of Figure 5 may start in a write command block 400, wherein a write command, that is, either a power write command or a user write command, is received.

In response to the reception of the write command, the block diagram 40 may proceed to a first checking block 402 that may be configured to verify whether the received write command is a power write command.

If the received write command is a power write command, the block diagram 40 may proceed, following the branch indicated with the reference Y₁ in Figure 5, to a first read bit block 404.

Otherwise, if the received write command is a user write command, the block diagram 40 may proceed, following the branch indicated with the reference N₁ in Figure 5, to a second read bit block 414.

In the first read bit block 404, the additional non-volatile bit associated to the part of the memory, for instance, a word of the memory, that is to be written according to the received write command can be read.

A second checking block 406 may be configured to verify whether the read value of the additional non-volatile bit indicates that the type of the latest pulse applied to such part of the memory is a power pulse.

For instance, such second checking block 406 may be configured to verify whether the value stored in the additional non-volatile bit corresponds to a high logic level.

If the read value of the additional non-volatile bit indicates that the type of the latest pulse applied to the part of the memory that is to be written is a power pulse, the block diagram 40 may proceed, following the branch indicated with the reference Y₂ in Figure 5, to a first writing block 408.

Otherwise, if the read value of the additional non-volatile bit indicates that the type of the latest pulse applied to the part of the memory that is to be written is a user pulse, the block diagram 40 may proceed, following the branch indicated with the reference N₂ in Figure 5, to a user to power writing block 412.

In the first writing block 408, a standard write operation may be performed according to the received write command, using power pulses.

In fact, since the previous write operation was performed using power pulses as indicated by the additional non-volatile bit, no issues arise when a further write operation using power pulses is to be performed.

Therefore, in such first writing block 408, the data stored in the cells comprised in the part of the memory that is to be written, that is, their states, can be verified and the power pulses can be sent only to those cells that have to change their states according to the received write command.

It is noted that the value of the additional non-volatile bit (indicated with the reference power bit PB_{Val} in Figure 5) is not modified in such first writing block 408, therefore, such additional non-volatile bit PB_{Val} indicates that the type of the latest pulse applied to such part of the memory is a power pulse.

For instance, the value of the additional non-volatile bit PB_{Val} provided as output by the first writing block 408 may be a high logic level.

Then, the block diagram 40 may proceed to an ending block 410.

In the user to power writing block 412, a write operation as the one previously described in the user to power writing step 304 may be performed according to the received write command, therefore, by applying power pulses to the cells comprised in such part of the memory that is to be written.

Again, the power pulses are applied to the cells of the part of the memory that is to be written even if such cells already store the expected data, thus, every cell comprised in the part of the memory that is to be written (and not only the cells that change their state) is to be re-written using power pulses even if it is already written via user pulses to the expected state.

In this way, it is possible to improve the retention of the content in each cell comprised in such part of the memory by writing such content using the higher currents of the power pulses instead of the lower currents of the user pulses.

In addition, in such user to power writing block 412, the additional non-volatile bit PB_{Val} associated to such part of the memory is modified in order to indicate that the type of the latest pulse applied to such part of memory is a power pulse.

For instance, the value of the additional non-volatile bit PB_{Val} provided as output by the user to power writing block 412 may be a high logic level.

It is noted that such modification of the value of the additional non-volatile bit PB_{Val} may be performed via power pulses in order to improve its retention.

Then, the block diagram 40 may proceed to the ending block 410.

In the second read bit block 414, the additional non-volatile bit associated to the part of the memory, for instance, a word of the memory, that is to be written according to the received write command can be read.

A third checking block 416 may be configured to verify whether the read value of the additional non-volatile bit indicates that the type of the latest pulse applied to such part of the memory is a power pulse.

For instance, such third checking block 416 may be configured to verify whether the value stored in the additional non-volatile bit corresponds to a high logic level.

If the read value of the additional non-volatile bit indicates that the type of the latest pulse applied to the part of the memory that is to be written is a power pulse, the block diagram 40 may proceed, following the branch indicated with the reference Y₃ in Figure 5, to a recovery or blanking sequence block 418.

Otherwise, if the read value of the additional non-volatile bit indicates that the type of the latest pulse applied to the part of the memory that is to be written is a user pulse, the block diagram 40 may proceed, following the branch indicated with the reference N₃ in Figure 5, to a second writing block 424.

The recovery or blanking sequence block 418 may be configured to apply the previously described recovery blanking pulse to the cells:
that are in a "reset" state as a consequence of a previous write operation performed using power pulses, and
that are comprised in the part of the memory that is to be written according to the received write command.

In such a way, as previously described, it is possible to mitigate, for instance, by removing, the effects of the cell "power memory effect", facilitating moving a PCM cell previously written via a reset write operation using a reset power pulse PR in a state comprised in a desired set cell distribution (that is, a set cell distribution related to a desired distribution opening window) by performing a set write operation using a set user pulse U_{SET} even if the set user pulse U_{SET} has a lower current value than the reset power pulse PR used for the previous reset write operation.

Therefore, the previously described problem related to the obtaining of a desired distribution opening window in order to facilitate reading operations is also mitigated.

Hence, the block diagram 40 may proceed to a clear bit block 420 wherein the additional non-volatile bit PB_{Val} associated to the part of the memory that is to be written can be modified in order to indicate that the type of the latest pulse applied to such part of memory is a user pulse.

For instance, the value of the additional non-volatile bit PB_{Val} may be modified in order to assume a low logic level.

Again, it is noted that the modification of the value of the additional non-volatile bit PB_{Val} may be performed via power pulses in order to improve its retention.

Then, the block diagram 40 may proceed to a power to user writing block 422, wherein a write operation as the one previously described in the power to user writing step 206 may be performed according to the received write command, therefore, by applying user pulses to the cells comprised in such part of the memory that is to be written.

Since the value of the additional non-volatile bit PB_{Val} may not be modified in the power to user writing block 422 (as it was already modified in the clear bit block 420), the value of the additional non-volatile bit PB_{Val} provided as output by such power to user writing block 422 may be, for instance, a low logic level.

Then, the block diagram 40 may proceed to the ending block 410.

In the second writing block 424, a standard write operation may be performed according to the received write command, using user pulses.

In fact, since the previous write operation was performed using user pulses as indicated by the additional non-volatile bit, no issues arise when a further write operation using user pulses is to be performed.

Therefore, in such second writing block 424, the data stored in the cells comprised in the part of the memory that is to be written, that is, their states, can be verified and the user pulses can be sent only to those cells that have to change their states according to the received write command.

It is noted that the value of the additional non-volatile bit PB_{Val} is not modified in such second writing block 424, therefore, such additional non-volatile bit PB_{Val} indicates that the type of the latest pulse applied to such part of the memory is a user pulse.

For instance, the value of the additional non-volatile bit PB_{Val} provided as output by the second writing block 424 may be a low logic level.

Then, the block diagram 40 may proceed to the ending block 410.

Therefore, solutions as described herein may refer to a method, for instance, a method according to the block diagram 40 described above, that comprises, for a writable memory section (such as a word) that has to be written via a write command and that is associated to a respective non-volatile memory section (for instance, to a respective additional non-volatile bit), performing the following operations:
in response to:
the information stored in the respective non-volatile memory section indicating, for instance, as a result of the operation performed in the first checking block 402 where is verified if the received write command is a power write command, a latest write operation performed on the writable memory section via pulses comprised in the first set of current pulses, that is, via power pulses, and
the received write command indicates to perform such write operation via pulses comprised in such first set of current pulses, that is, if the write command is a power write command indicating to perform the write operation via power pulses comprised in such first set,
keeping, following the branches indicated with the references Y₁ and Y₂ of Figure 5, the first set of current pulses comprising the power pulses to perform the write operation; and
if such first set of current pulses comprising the power pulses is kept to perform the write operation:
   maintaining, for instance, as described in the first writing block 408, the information stored in the respective non-volatile memory section to indicate a latest write operation performed on the writable memory section via pulses comprised in the first set of current pulses, that is, via power pulses; and
   performing, for instance, again as described in the first writing block 408, the write operation on the writable memory section via pulses comprised in the first set of current pulses, that is, via power pulses, by applying such pulses (preferably only) to the cells that have to change their states.

Similarly, the method according to solutions as described herein, for instance, the method according to the block diagram 40 described above, may comprise, for a writable memory section (such as a word) that has to be written via a write command and that is associated to a respective non-volatile memory section (for instance, to a respective additional non-volatile bit), performing the following operations:
in response to:
the information stored in the respective non-volatile memory section indicating, for instance, as a result of the operation performed in the first checking block 402 where is verified if the received write command is a power write command, a latest write operation performed on the writable memory section via pulses comprised in the second set of current pulses, that is, via user pulses, and
the received write command indicates to perform such write operation via pulses comprised in such second set of current pulses, that is, if the write command is a user write command indicating to perform the write operation via user pulses comprised in such second set,
keeping, following the branches indicated with the references N₁ and N₃ of Figure 5, the second set of current pulses comprising the user pulses to perform the write operation; and
if such second set of current pulses comprising the user pulses is kept to perform the write operation:
   maintaining, for instance, as described in the second writing block 424, the information stored in the respective non-volatile memory section to indicate a latest write operation performed on the writable memory section via pulses comprised in the second set of current pulses, that is, via user pulses; and
   performing, for instance, again as described in the second writing block 424, the write operation on the writable memory section via pulses comprised in the second set of current pulses, that is, via user pulses, by applying such pulses (preferably only) to the cells that have to change their states.

It is noted that in solutions according to the present description, the operation of setting of the information stored in the respective non-volatile memory section, that is, the additional non-volatile bit(s), for instance, in the power to user writing step 206, user to power writing step 304, and/or in the clear bit block 420 described above, may be performed via pulses comprised in the first set of current pulses, that is, via power pulses, in order to improve retention.

It is noted that solutions as described herein may be applied to different types of phase change memories, for instance, to:
single-ended NVM PCMs, that is, non-volatile phase change memories having 1 cell/bit architecture;
two-cells-per-bit NVM PCMs, that is, non-volatile phase change memories having 2 cells/bit architecture; and
multi-level NVM PCMs, that is, non-volatile phase change memories having Multi Level architecture, thus, configured to store more than one bit for each cell.

It is noted that even if the additional non-volatile bit has been described as associated to each memory address addressing a given part of the memory (for instance, to each memory address addressing a word of the memory), different granularities may also be considered.

For instance, the granularity of the part of the memory associated to the additional non-volatile bit may comprise:
a single word of the memory;
a plurality of words of the memory, for instance, a page composed of 16 words; or
part of a word, for instance, a single byte of the word.

It is noted that even if the modification of the value of the additional non-volatile bit has been described as performed via power pulses in order to improve its retention, it is also possible to modify the value of such additional non-volatile bit via user pulses.

It is noted that the additional non-volatile bit may also be mapped using redundancy, therefore, the role of the additional non-volatile bit may be implemented via a plurality of additional non-volatile bits, for instance, 3 bits and the state of the resulting indication is decided based on the value of the majority of the bits.

Therefore, in solutions as described herein, the non-volatile memory section, for instance, one or more additional non-volatile bits, associated with a writable memory section, for instance, a word of the memory, may be configured to have stored therein, preferably via a plurality of redundant bits in order to be able to detect and correct errors in the information stored therein, either a first logic level or a second logic level out of a high logic level or a low logic level, such first logic level being different from such second logic level.

For example, the first logic level may be a high logic level and the second logic lever may be a low logic level. Similarly, the first logic level may be a low logic level and the second logic level may be a high logic level.

Therefore, according to the description above, if such logic level corresponds to such first logic level, such logic level indicates a latest write operation performed on the writable memory section via pulses comprised in the first set of current pulses, that is, via power pulses.

Differently, if such logic level corresponds to such second logic level, such logic level indicates a latest write operation performed on the writable memory section via pulses comprised in the second set of current pulses, that is, via user pulses.

In solutions as described herein, such writable memory section, that is, such memory section that can be written in response to a power or user write command, may be:
a single word of the PCM device;
a plurality of words of the PCM device, for example, a page of the PCM device; or
a part of a word of the PCM device, for example, a single byte of the word.

In addition, solutions as described herein may refer to PCM devices having:
single-ended architecture, that is, one cell per bit architecture;
two-cells-per-bit architecture, that is, two cells per bit architecture; or
multi-level architecture, that is, architecture configured to store a plurality of bits for each cell.

Solutions as described herein facilitate achieving a method of performing write operations in Phase Change Memory, PCM, devices comprising writable memory sections, for instance, a plurality of words of the memory.

Each writable memory section, for instance, a word of the memory, is coupled to a respective non-volatile memory section, for instance, an additional non-volatile bit(s), having stored therein information indicating whether the latest write operation performed on the writable memory section has been performed via pulses comprised in a first set of current pulses (which are also referred to as power pulses in the description above) or in a second set of current pulses (which are also referred to as user pulses in the description above).

It is noted that said second set of current pulses comprising pulses, that is, user pulses, having lower current values than pulses, that is, power pulses, comprised in said first set of current pulses.

The method described herein comprises:
receiving a command to perform a write operation on a writable memory section, for instance, on a word of the memory, via pulses comprised in either the first set of current pulses or the second set of current pulses, therefore, receiving a command to perform a write operation via pulses comprised in the first set of current pulses (that is, a power write command indicating to perform a write operation via power pulses) or a command to perform a write operation via pulses comprised in the second set of current pulses (that is, a user write command indicating to perform a write operation via user pulses);
in response to the information stored in the respective non-volatile memory section indicating a latest write operation performed on the writable memory section via pulses comprised in the first set of current pulses, that is, via power pulses, and the received command indicating to perform said write operation via pulses comprised in the second set of current pulses, that is, via user pulses, detecting a transition from the first set of current pulses, that is, from power pulses, to the second set of current pulses, that is, to user pulses; and
in response to detection of a transition from the first set of current pulses to the second set of current pulses:
   applying a blanking current pulse, that is, a current pulse able to mitigate, for instance, to remove, the effects of the previously described cell "power memory effect", to cells of the writable memory section that are in a "reset" state;
   setting the information stored in the respective non-volatile memory section to indicate a latest write operation performed on the writable memory section via pulses comprised in the second set of current pulses, that is, via user pulses; and
   performing the write operation on the writable memory section via pulses comprised in the second set of current pulses, that is, via "set" user current pulses and/or "reset" user current pulses comprised in the second set of current pulses.

In solutions as described herein, the method may comprise:
in response to the information stored in the respective non-volatile memory section indicating a latest write operation performed on the writable memory section via pulses comprised in the second set of current pulses, that is, via user pulses, and the received command indicates to perform said write operation via pulses comprised in the first set of current pulses, that is, via power pulses, detecting a transition from the second set of current pulses, that is, from user pulses, to the first set of current pulses, that is, to power pulses; and
if a transition from the second set of current pulses to the first set of current pulses is detected:
   setting the information stored in the respective non-volatile memory section to indicate a latest write operation performed on the writable memory section via pulses comprised in the first set of current pulses, that is, via power pulses; and
   performing the write operation on the writable memory section via pulses comprised in the first set of current pulses, that is, via power pulses, by applying said pulses to all the cells of the writable memory section irrespective of their state being a set or a reset state.

Solutions as described herein also refers to a Phase Change Memory, PCM, device comprising writable memory sections, for instance, a plurality of words.

Each writable memory section, for instance, a word of the memory, is coupled to a respective non-volatile memory section, for instance, an additional non-volatile bit(s), having stored therein information indicating whether the latest write operation performed on the writable memory section has been performed via pulses comprised in a first set of current pulses, that is, via power pulses, or in a second set of current pulses, that is, via user pulses, such second set of current pulses comprising pulses having lower current values than pulses comprised in such first set of current pulses.

The PCM device is configured to implement the method 20, 30, or 40 according to the previous description.

In addition, solutions as described herein also refers to a computer program product loadable in a control unit of a Phase Change Memory, PCM, device, the PCM device comprising writable memory sections, for instance, a plurality of words of the memory.

Each writable memory section, for instance, each word, is coupled to a respective non-volatile memory section, for instance, an additional non-volatile bit(s), having stored therein information indicating whether the latest write operation performed on the writable memory section has been performed via pulses comprised in a first set of current pulses, that is, via power pulses, or in a second set of current pulses, that is, via user pulses, such second set of current pulses comprising pulses having lower current values than pulses comprised in such first set of current pulses.

The computer program product comprises portions of software code configured to cause the PCM device to implement the method 20, 30, or 40 according to the present description in response to the computer program product being run in the control unit of the PCM device.

Thus, solutions as described herein facilitate the transition between the use of power pulses and the use of user pulses in write operations in order to reduce the degradation of the PCM cells during cycles of writing operations (present when only power pulses are considered) without losing or compromising (if only user pulses are considered) retention capabilities at high temperatures, for instance, during soldering.

Without prejudice to the underlying principles, the details and the embodiments may vary, even significantly, with respect to what has been described by way of example only without departing from the scope of the embodiments.

The extent of protection is determined by the annexed claims.

## Claims

1. A method (20; 40) of performing write operations in Phase Change Memory, PCM, devices (ARR) comprising writable memory sections, each writable memory section being coupled to a respective non-volatile memory section having stored therein information indicating whether the latest write operation performed on the writable memory section has been performed via pulses comprised in a first set of current pulses or in a second set of current pulses, said second set of current pulses comprising pulses having lower current values than pulses comprised in said first set of current pulses,
wherein the method (20; 40) comprises:
receiving (202; 400) a command to perform a write operation on a writable memory section via pulses comprised in either the first set of current pulses or the second set of current pulses;
in response to the information stored in the respective non-volatile memory section indicating (202; 402) a latest write operation performed on the writable memory section via pulses comprised in the first set of current pulses and the received command indicating to perform said write operation via pulses comprised in the second set of current pulses, detecting (202; N₁, Y₃) a transition from the first set of current pulses to the second set of current pulses; and
in response to detection (202; N₁, Y₃) of a transition from the first set of current pulses to the second set of current pulses:
applying (204; 418) a third current pulse to cells of the writable memory section that are in a reset state;
setting (206; 420) the information stored in the respective non-volatile memory section to indicate a latest write operation performed on the writable memory section via pulses comprised in the second set of current pulses; and
performing (206; 422) the write operation on the writable memory section via pulses comprised in the second set of current pulses.

2. The method (30; 40) according to claim 1, comprising:
in response to the information stored in the respective non-volatile memory section indicating (302; 402) a latest write operation performed on the writable memory section via pulses comprised in the second set of current pulses and the received command indicating to perform said write operation via pulses comprised in the first set of current pulses, detecting (302; Y₁, N₂) a transition from the second set of current pulses to the first set of current pulses; and
if a transition from the second set of current pulses to the first set of current pulses is detected (302; Y₁, N₂):
setting (304; 412) the information stored in the respective non-volatile memory section to indicate a latest write operation performed on the writable memory section via pulses comprised in the first set of current pulses; and
performing (304; 422) the write operation on the writable memory section via pulses comprised in the first set of current pulses by applying said pulses to all the cells of the writable memory section irrespective of their state being a set or a reset state.

3. The method (20; 30; 40) according to claim 1 or claim 2, wherein each writable memory section is addressable via a respective memory address and wherein said non-volatile memory section is comprised:
in said respective memory address; or
in a group of bits, preferably a word, coupled to said respective memory address.

4. The method (20; 30; 40) according to any one of the previous claims, wherein said respective non-volatile memory section is configured to have stored therein, preferably via a plurality of redundant bits, either a first logic level or a second logic level out of a high logic level or a low logic level, said first logic level being different from said second logic level, wherein:
said logic level being said first logic level indicates a latest write operation performed on the writable memory section via pulses comprised in the first set of current pulses; and
said logic level being said second logic level indicates a latest write operation performed on the writable memory section via pulses comprised in the second set of current pulses.

5. The method (40) according to any one of the previous claims, comprising:
in response to the information stored in the respective non-volatile memory section indicating (402) a latest write operation performed on the writable memory section via pulses comprised in the first set of current pulses and the received command indicates to perform said write operation via pulses comprised in said first set of current pulses, keeping (Y₁, Y₂) the first set of current pulses; and
if said first set of current pulses is kept (Y₁, Y₂):
maintaining (408) the information stored in the respective non-volatile memory section to indicate a latest write operation performed on the writable memory section via pulses comprised in the first set of current pulses; and
performing (408) the write operation on the writable memory section via pulses comprised in the first set of current pulses by applying said pulses to the cells that have to change their states.

6. The method (40) according to any one of the previous claims, comprising:
in response to the information stored in the respective non-volatile memory section indicating (402) a latest write operation performed on the writable memory section via pulses comprised in the second set of current pulses and the received command indicates to perform said write operation via pulses comprised in said second set of current pulses, keeping (N₁, N₃) the second set of current pulses; and
if said second set of current pulses is kept (N₁, N₃):
maintaining (424) the information stored in the respective non-volatile memory section to indicate a latest write operation performed on the writable memory section via pulses comprised in the second set of current pulses; and
performing (424) the write operation on the writable memory section via pulses comprised in the second set of current pulses by applying said pulses to the cells that have to change their states.

7. The method (20; 30; 40) according to any one of the previous claims, wherein said setting (206; 304; 420) of the information stored in the respective non-volatile memory section is performed via pulses comprised in the first set of current pulses.

8. The method (20; 30; 40) according to any one of the previous claims, wherein said writable memory section is:
a single word of the PCM device;
a plurality of words of the PCM device, preferably a page of the PCM device; or
a part of a word of the PCM device, preferably a single byte of the word.

9. The method (20; 30; 40) according to any one of the previous claims, wherein the PCM device is:
a single-ended PCM having one cell per bit architecture;
a two-cells-per-bit PCM having two cells per bit architecture; or
a multi-level PCM configured to store a plurality of bits for each cell.

10. A Phase Change Memory, PCM, device (ARR) comprising writable memory sections, each writable memory section being coupled to a respective non-volatile memory section having stored therein information indicating whether the latest write operation performed on the writable memory section has been performed via pulses comprised in a first set of current pulses or in a second set of current pulses, said second set of current pulses comprising pulses having lower current values than pulses comprised in said first set of current pulses;
the PCM device (ARR) being configured to implement the method (20, 30, 40) according to any one of the previous claims.

11. A computer program product loadable in a control unit of a Phase Change Memory, PCM, device (ARR), the PCM device (ARR) comprising writable memory sections, each writable memory section being coupled to a respective non-volatile memory section having stored therein information indicating whether the latest write operation performed on the writable memory section has been performed via pulses comprised in a first set of current pulses or in a second set of current pulses, said second set of current pulses comprising pulses having lower current values than pulses comprised in said first set of current pulses;
the computer program product comprising portions of software code configured to cause the PCM device (ARR) to implement the method (20, 30, 40) according to any one of claims 1 to 9 in response to the computer program product being run in the control unit of the PCM device (ARR).
